# EUROPEAN PATENT APPLICATION

(11) **EP 2 068 339 A1**
(43) Date of publication of application: **10.06.2009**
(21) Application number: 07828468.4
(22) Date of filing: 26.09.2007
(51) Int. Cl.: H01J 1/304, H01J 37/063, H01J 37/073

(54) **ELECTRON SOURCE**

(30) Priority: 27.09.2006 JP 2006261668
(71) Applicant: Denki Kagaku Kogyo Kabushiki Kaisha, Tokyo 103-8338 (JP)
(72) Inventor: TERUI, Yoshinori, Gunma 377-8520 (JP); NAKAHARA, Fumihiro, Gunma 377-8520 (JP); SAKAWA, Seiichi, Gunma 377-8520 (JP)
(74) Representative: Hartz, Nikolai
(86) International application number: PCT/JP2007/068722
(87) International publication number: WO 2008/038684

(57) **Abstract**

An electron source showing little surplus current even at a time of high angular intensity operation is provided. An electron source comprising an electron emitting portion, a suppressor electrode and an extractor electrode, wherein the electron emitting portion is present at a leading edge of an end of a single crystal rod having a shape comprising a first truncated cone portion or a cone portion, and a second truncated cone portion continuing therefrom. It is preferably the electron source, wherein the single crystal rod has an oxide of a metal element selected from the group consisting of Ca, Sr, Ba, Sc, Y, La, Ti, Zr, Hf and lanthanoide elements as a diffusion source, and the single crystal rod is made of tungsten or molybden of <100> orientation.

## Description

### TECHNICAL FIELD

The present invention relates to an electron source required to perform high angular intensity operation that is to be used for e.g. an electron beam lithography machine, a wafer inspection apparatus or an electron beam LSI tester.

### BACKGROUND ART

In recent years, in order to obtain an electron beam having higher brightness and longer operating life than a thermionic cathode, an electron source (hereinafter referred to as a ZrO/W electron source) employing a cathode made of a needle electrode of tungsten single crystal provided with a covering layer comprising zirconium and oxygen, has been used (Non-Patent Document 1).

The ZrO/W electron source is one wherein a diffusing source made of zirconium oxide is provided on a needle cathode of tungsten single crystal having an axial orientation being <100> orientation, so that zirconium and oxygen are diffused to form a covering layer (hereinafter referred to as a "ZrO covering layer") so as to reduce the work function of the {100} crystallographic plane of tungsten single crystal to a level of from 4.5 eV to 2.8 eV. Particularly, only the very small crystallographic facet corresponding to the {100} crystallographic plane formed at the forward end of the cathode becomes an electron emission area, whereby an electron beam having a higher brightness than by a conventional thermionic cathode can be obtained, and yet this electron source has such a characteristic that it has a longer operating life. Further, such an electron source has characteristics such that it is more stable than a cold field emission electron source and is operable even under a low vacuum degree and thus easy to use (Non-Patent Document 2).

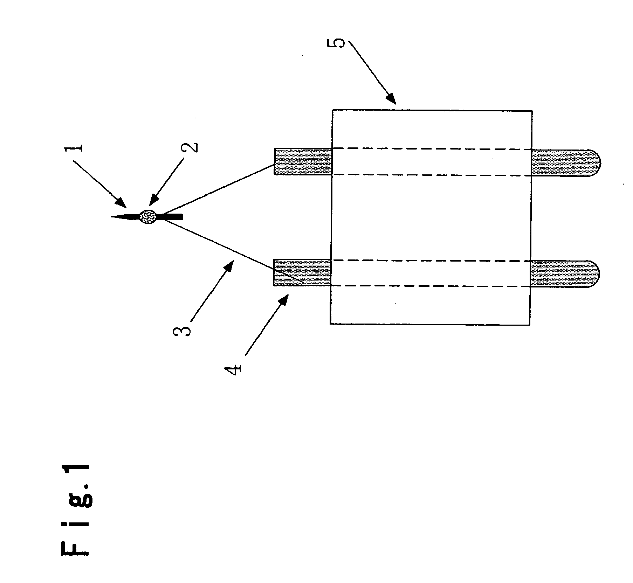

As shown in Fig. 1, in the ZrO/W electron source, a single crystal rod 1 of tungsten having <100> orientation which emits an electron beam, is fixed by e.g. welding to a predetermined position of a tungsten filament 3 provided on conductive terminals 4 fixed to an insulator 5. The single crystal rod 1 has a sharp edge formed by electropolishing, and electrons are emitted mainly from this sharp edge. A diffusing source 2 containing zirconium and oxygen is formed at a portion of the single crystal rod 1. The surface of the cathode 1 is covered with a ZrO covering layer (not shown).

The single crystal rod 1 is Joule heated by the filament 3 and used usually at a temperature of about 1,800 K. Accordingly, the ZrO covering layer on the surface of the single crystal rod 1 will be lost by evaporation. However, from the diffusing source 2, zirconium and oxygen will diffuse and will be continuously supplied to the surface of the single crystal rod 1, and consequently, the ZrO covering layer will be maintained.

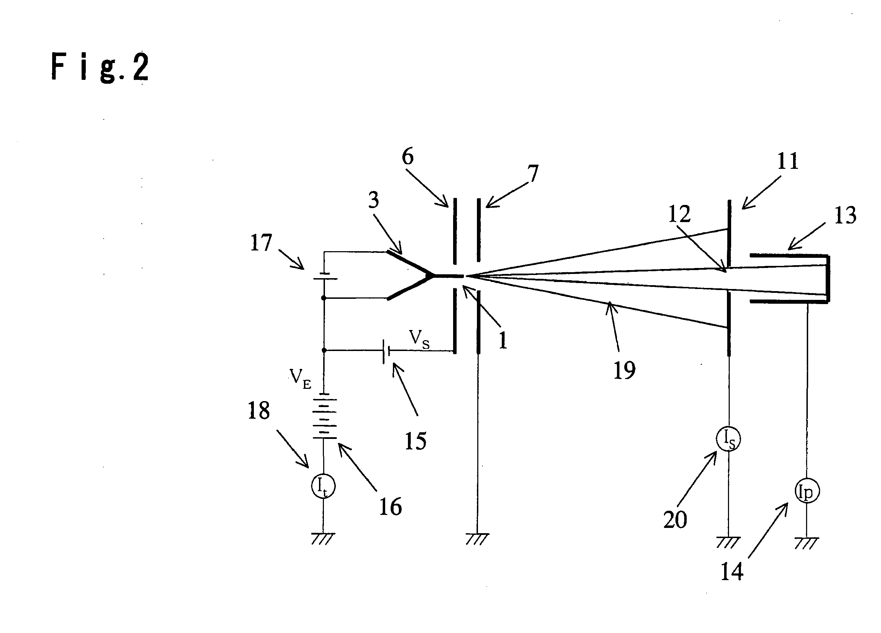

When the ZrO/W electron source is used, the forward end of the single crystal rod 1 is disposed between a suppressor electrode 6 and an extractor electrode 7 (refer to Fig. 2). To the single crystal rod 1 that is a cathode, a high voltage negative against the extractor electrode is applied, and to the suppressor electrode, a negative suppressor voltage at a level of a few hundred volts against the single crystal rod 1 is applied to suppress thermionic electrons from the filament 3.

In a CD-SEM (Scanning Electron Microscope) or a review SEM to be used at a low accelerating voltage, the ZrO/W electron source is operated at an angular intensity of from 0.1 to 0.2 mA/sr since stable probe current and suppressed spread of energy width are obtained in this condition.

Meanwhile, in an electron beam lithography machine, an wafer inspection apparatus and an electron beam LSI tester, etc., since throughput is important, an electron source is operated at a high angular intensity of about 0.4 mA/sr. In such an application in which throughput is important, still higher angular intensity is desired, and operation of high angular intensity of 1.0 mA/sr, that is high current operation, is required in some cases.

However, in a commonly known ZrO/W electron source, a single crystal rod 1 has a needle shape whose leading edge has a curvature radius of from submicron to about 1 µm, and such an electron source has such a demerit that (1) upper limit of angular intensity is only about 1.0 mA/sr at a time of high angular intensity operation, and that (2) at this time, an extraction voltage to be applied between a cathode and an extraction electrode is as high as at least 4 kV, whereby the electric field intensity at the leading edge of the chip becomes extremely high intensity of from 0.4×10⁹ to 1.0×10⁹ V/m, and frequency of failure due to arc discharge increases (refer to Non-Patent Document 3).

Further, as an alternative of zirconium in ZrO/W electron source, an element such as scandium, barium or yttrium is known (refer to Non-Patent Documents 4 and 5).

For this reason, as an electron source suitable for high current operation, an electron source having a truncated cone portion having a full cone angle of from 25° to 95° and a flat face of from 5 µm to 200 µm in diameter as the top face, which is a single crystal of tungsten or molybden coated with a coating layer of a metal element selected from the group consisting of 2A, 3A and 4A groups and oxygen, is proposed (refer to Patent Document 1).

Further, in general, an electron source suitable for high current operation is desired to show little unnecessary current discharged off axis, that is, little surplus current.

Patent Document 1: WO2004/073010

Non-Patent Document 1: D. Tuggle, J. Vac. Sci. Technol. 16, p1699 (1979)

Non-Patent Document 2: M.J. Fransen, "On the Electron-Optical Properties of the ZrO/W Schottky Electron Emitter", ADVANCES IN IMAGING AND ELECTRON PHYSICS, VOL. III, p91-166, 1999 by Academic Press.

Non-Patent Document 3: D.W. Tuggle, J. Vac. Sci. Technol. B3(1), p220 (1985)

Non-Patent Document 4: Oyo Butsuri (Applied Physics) vol.71, No.4 (2002) 438-442

Non-Patent Document 5: Proc. Int. Display Workshop 2003, 1219-1222

### DISCLOSURE OF THE INVENTION

### PROBLEMS TO BE SOLVED BY THE INVENTION

However, the above-mentioned known electron source suitable for high current operation still has a problem that it has large surplus current. Namely, it is an object of the present invention to provide an electron source which has less surplus current even at a time of high angular intensity operation.

### MEANS FOR SOLVING THE PROBLEMS

The present inventors have produced various types of prototype light sources to evaluate the amount of surplus current and conducted e.g. simulation of potential distribution, to achieve the present invention.

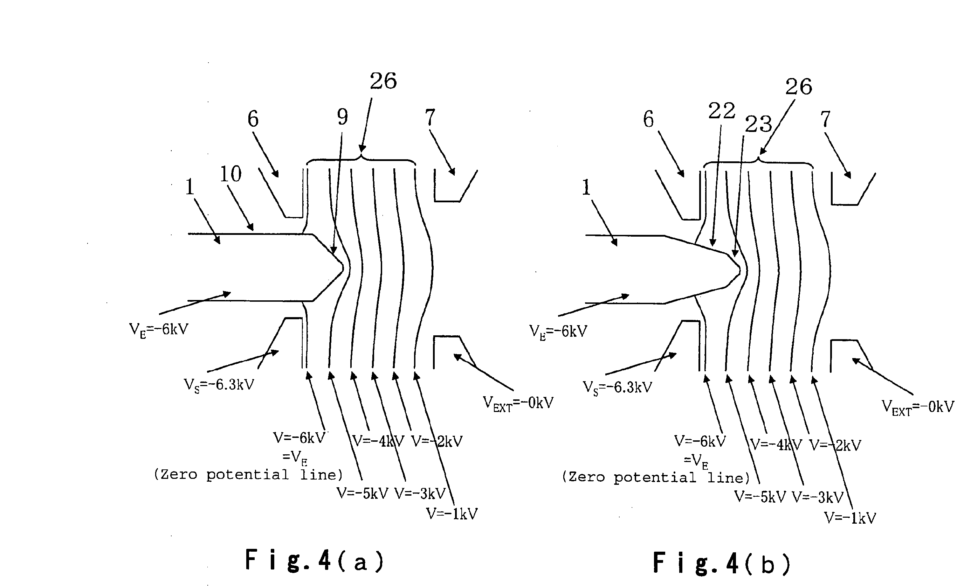

Namely, the present inventors have discovered that in an electron source, high surplus current is generated when a zero potential line crosses not a cone face of the cone portion 9 but a side face 10 of the single crystal rod 1, where the zero potential line is an isoelectric line of the same potential as that of the single crystal rod 1 in a potential distribution formed among a single crystal rod 1 to which high negative voltage is applied with respect to an extractor electrode 7, that is a cathode, a suppressor electrode 6 and the extractor electrode 7. Fig. 4(a) shows the nature of isoelectric line under the conditions that the emitter voltage V_{E} is -6,000 V and the suppressor voltage V_{S} is -300 V with respect to the single crystal rod 1.

It is possible to make the zero potential line do not cross the side face 10 of the single crystal rod 1, by reducing the distance between the leading edge of the rod and the suppressor electrode 6 or by reducing a full apex angle 21 of the cone portion, but such a change of geometric shape causes change of electrooptical properties.

To cope with this problem, the present inventors have discovered that by forming an electron emitting portion, that is an end of a single crystal rod, into a shape comprising a first truncated cone portion or a cone portion and a second truncated cone portion continuing therefrom, the zero potential line crosses a cone face of the second truncated cone portion, whereby surplus current can be suppressed (refer to Fig. 4(b)).

In the case of employing this shape, the electrooptical characteristics are determined by the full apex angle 25 of the first truncated cone portion or the cone portion and dimensions of the electron emitting portion, and they are not influenced by the full apex angle 24 of the second truncated cone portion, and accordingly, it is possible to satisfy both design of electron gun having geometric shape and dimensions from which desired electrooptical characteristics are expected, and suppression of surplus current.

Thus, according to the present invention, in an electron source having an electron emitting portion at an end of a single crystal rod, it is possible to achieve preferred electrooptical characteristics in which surplus current is controlled, by making the shape of the electron emitting portion of single crystal rod and its vicinity into a specific shape.

The present invention has a gist having the following characteristics.
(1) An electron source comprising an electron emitting portion, a suppressor electrode and an extractor electrode, wherein the electron emitting portion is present at a leading edge of an end of a single crystal rod having a shape comprising a first truncated cone portion or a cone portion, and a second truncated cone portion continuing therefrom.
(2) The electron source according to the above (1), wherein the single crystal rod has an oxide of a metal element selected from the group consisting of Ca, Sr, Ba, Sc, Y, La, Ti, Zr, Hf and lanthanoide elements as a diffusion source, and the single crystal rod is made of tungsten or molybden of <100> orientation.
(3) The electron source according to the above (1) or (2), wherein the electron emitting portion is present between the suppressor electrode and the extractor electrode.
(4) The electron source according to any one of the above (1) to (3), wherein the apex angle of the first truncated cone portion or the cone portion is at least 60° and at most 150° in terms of full angle, and the apex angle of the second truncated cone portion is at least 20° in terms of full angle.
(5) The electron source according to any one of the above (1) to (4), wherein the electron emitting portion comprises a flat face, and the flat face is within 1° from {100} crystal plane in terms of angle difference.
(6) The electron source according to any one of the above (1) to (4), wherein the electron emitting portion comprises a part of a spherical face.

### EFFECT OF THE INVENTION

The electron source of the present invention has little surplus current, which does not sacrifice electrooptical characteristics for adjustment of the geometric shape or the dimensions of electron gun in order to suppress surplus current, and is suitable as a high current electron source.

### BRIEF DESCRIPTION OF THE DRAWINGS

Fig. 1: A view explaining the construction of electron source.
Fig. 2: A schematic view of an apparatus for evaluating electron emission characteristics of electron source.
Fig. 3: A view explaining the shape of an end portion of single crystal rod.
Fig. 4: An isopotential map.
Fig. 5: A view showing electron emission characteristic of a known electron source.
Fig. 6: A view showing electron emission characteristic of electron sources according to Examples and Comparative Examples.

### EXPLANATION OF NUMERALS

1: Single crystal rod
2: Diffusion source
3: Filament
4: Conductive terminal
5: Insulator
6: Suppressor electrode
7: Extractor electrode
8: Electron emitting portion
9: Cone portion
10: Side face (of single crystal rod)
11: Screen electrode
12: Aperture
13: Cup-shaped electrode
14: Micro electric current meter
15: Suppressor power source
16: High voltage power source
17: Filament-heating power source
18: Electric current meter
19: Emitted electron beam
20: Microelectric current meter
21: Full apex angle
22: Second truncated cone portion
23: First truncated cone portion or cone portion
24: Full apex angle of second truncated cone portion
25: Full apex angle of first truncated cone portion or cone portion
26: Isoelectric line

### BEST MODE FOR CARRYING OUT THE INVENTION

Specific embodiments of the present invention will be described in detail below using as an Example a case of employing zirconium oxide as a diffusion source.

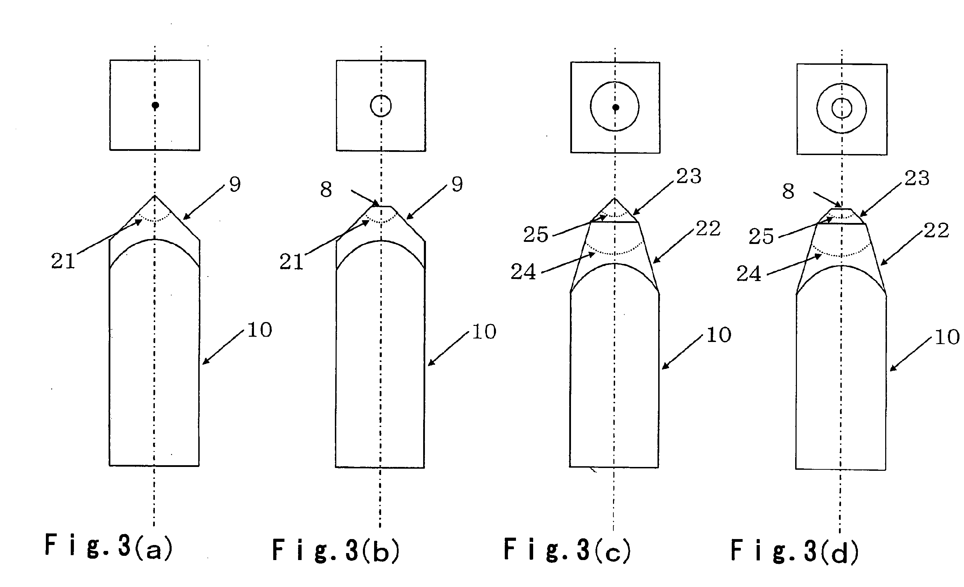

First of all, to a conductive terminal 4 brazed to an insulator 5, a filament 3 made of tungsten is fixed by spot welding (refer to Fig. 1). Next, to an end of a single crystal of tungsten having <100> orientation fabricated into a rectangular solid by machining, a cone portion 9 having a full apex angle 21 of 90° is formed by using a diamond paste and a grinding machine, and further, the apex of the cone portion 9 is polished with a diamond paste to form an electron emitting portion 8 having a diameter of 15 µm, to form a single crystal rod 1 (refer to Figs. 3(a) and 3(b)).

This single crystal rod 1 is attached to the filament 3 by spot welding. This single crystal rod 1 functions as a cathode.

A paste-form mixture of pulverized hydrogened zirconium and isoamyl acetate is applied to a part of the single crystal rod 1. After the isoamyl acetate is evaporated, the single crystal 1 is introduced into an ultrahigh vacuum apparatus. Subsequently, inside of the apparatus is evacuated to a ultrahigh vacuum of preferably from 3×10⁻¹⁰ Torr (4×10⁻⁸ Pa) to 3×10⁻⁹ Torr (4×10⁻⁷ Pa) and electric current is applied to the filament 3 to heat the single crystal rod 1 to 1,800 K, to thereby thermally decompose hydrogened zirconium to form metal zirconium. Subsequently, oxygen gas is introduced into the apparatus so that the pressure inside becomes preferably 1×10⁻⁶ Torr (1.3×10⁻⁴ Pa) to 3×10⁻⁶ Torr (4×10⁻⁴ Pa) to oxidize the metal zirconium to form a diffusion source 2 for zirconium and oxide, which is made of zirconium oxide.

The electron source taken out from the ultrahigh vacuum apparatus is attached to a measurement apparatus having an electrode arrangement shown in Fig. 2. The leading edge of the single crystal rod 1 is disposed between a suppressor electrode 6 and an extractor electrode 7. Here, in the specific example of the present invention, the distance between the leading edge of single crystal rod 1 and the suppressor electrode 6 is 0.25 mm, the distance between the suppressor electrode 6 and the extractor electrode 7 is 0.8 mm, the diameter of a hole of the extractor electrode 7 is 0.8 mm and the diameter of a hole of the suppressor electrode 6 is 0.6 mm.

The filament 3 is connected to a filament-heating power source 17, and further to a high voltage power source 16, and a high negative voltage with respect to the extractor electrode 7 is applied to the filament 3 as an emitter voltage V_{E}. Further, the suppressor electrode 6 is connected to a suppressor power source 15, and a negative voltage with respect to the single crystal rod 1 and the filament 3 is further applied to the suppressor electrode 6 as a suppressor voltage V_{S}. By this construction, emission of hot electrons from filament 3 is shielded. Total emission current It is measured by an electric current meter 18 disposed between the high voltage power source 16 and earth. Emission electron beam 19 emitted from the leading edge of the single crystal rod 1 passes through a hole of the extractor electrode 7 and reaches to a screen electrode 11. In the center of the screen electrode 11, an aperture 12 (small hole) is present, and a probe current Ip passing through the aperture and reaching to a cup-shaped electrode 13 is measured by a microelectric current meter 14.

Here, provided that a solid angle calculated from the distance between the aperture 12 and the leading edge of the single crystal rod 1 and the inner diameter of the aperture 12 is designated as ω, the angular intensity Iₚ' becomes Iₚ/ω. Further, between the screen electrode 11 and earth, a microelectric current meter 25 for measuring screen current I_{S} is disposed. Since the inner diameter of the aperture 12 is extremely small, the screen electrode Is corresponds to all electric current passing through the hole of the extractor electrode 7. Although not shown, provided that extractor electrode current flowing through the extractor electrode 7 to the earth is designated as I_{EXT}, a relation of electric currents is represented as I_{EXT}=Iₜ-I_{S}.

Subsequently, while inside of the measurement apparatus is evacuated to a ultrahigh vacuum of 3×10⁻¹⁰ Torr (4×10⁻⁸ Pa) and the temperature of the single crystal rod 1 is maintained at 1,700 K or 1,800 K, a suppressor voltage V_{S}=-300 V is applied to the suppressor 6 with respect to the single crystal rod 1, and subsequently, an emitter voltage V_{E}=-6,000 V of high voltage is applied to the single crystal rod 1, this status is maintained for a few hours, and when emission current is stabilized, total emission current It, screen current I_{S} and probe current Ip are measured.

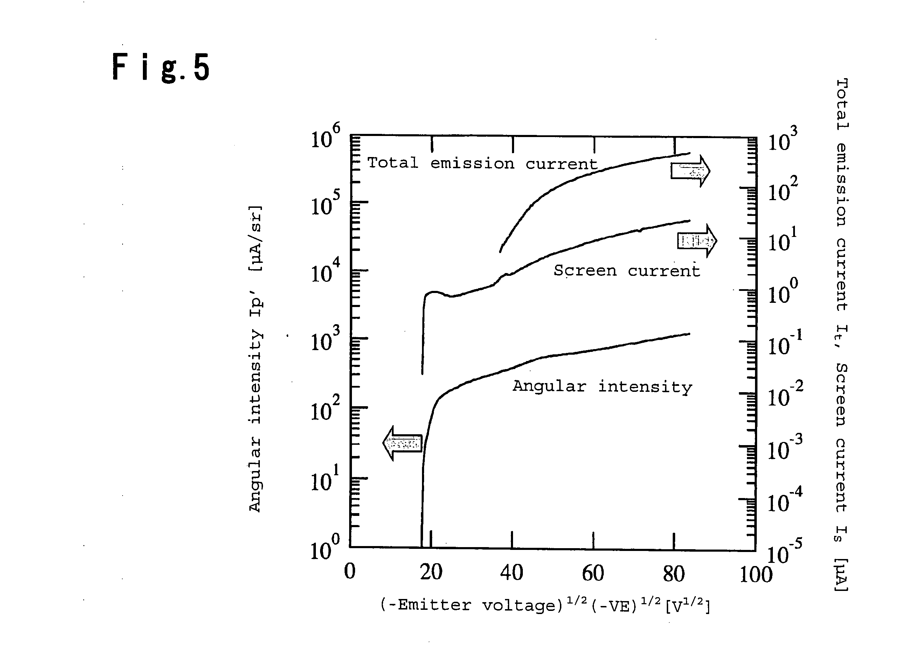

Fig. 5 shows angular intensity Ip' and total emission current It in relation to emitter voltage (shottky plot) of a conventional electron source measured under the condition that a suppressor voltage V_{S} with respect to the extractor electrode 7 was set to -400 V. When the total emission current It and the screen current Is are compared, it is understandable that the total emission current Iₜ is extremely higher than the screen current Is. This shows that since I_{EXT}=Iₜ-I_{S} is satisfied as described above, the extractor electrode current I_{EXT} flowing from the single crystal rod 1 to the extractor electrode 7 is high.

The extractor electrode current I_{EXT} flowing into the extractor current 7 deteriorates the performance of electron source since it separates and ionizes molecules adsorbed on a surface of the extractor electrode 7, whereby ions thus generated are accelerated towards the electron emission portion 8 and impact the surface. Namely, the extractor electrode current I_{EXT} flowing into the extractor electrode 7 is the main cause of surplus current, and it is preferably little.

Further, surplus current can be reduced to a certain extent by increasing suppressor voltage V_{S} or adjusting geometrical dimensions of the single crystal rod 1 and the suppressor electrode 6 or the positional relationship of them, but these measures do not substantially solve the problem (refer to e.g. JP-A-2006-032195).

Further, in general, electrooptical characteristics such as brightness or source diameter of electron source depends strongly on physical shapes or dimensions of electron emitting portion and electrode (refer to e.g. SCANNING ELECTRON MICROSCOPY/1982/II (Pages 473-483), SEM Inc., AMF O'Hare (Chicago), IL 60666, USA).

For this reason, it is not preferred to adjust geometric shape and dimensions of an electron source for suppressing surplus current.

In the present invention, first of all, a tungsten single crystal of <100> orientation is cut into a rectangular solid by electric discharge machining, and is fabricated into the shape of Fig. 3(c) by mechanical polishing. The apex of the cone portion 23 is further polished with a diamond polishing agent to remove fabrication damage to provide an electron emitting portion 8 (refer to Fig. 3(d)). The full apex angle 25 of a first truncated cone portion or cone portion 23 is at least 60° and at most 150°, preferably at least 80° and at most 120°, and the full apex angle of a second truncated cone portion 22 is at least 20°, preferably at least 30°. When the shape in the vicinity of electron emitting portion has such angles, control of surplus current becomes possible when such an electron emitting portion is employed in an electron source, and preferred electrooptical characteristics can be obtained.

The electron emitting portion 8 is positioned at the leading edge portion of the first truncated cone portion or cone portion, and its shape is a flat face in the former case, but in this case, its diameter is from 2 to 200 µm, preferably from 10 to 70 µm, and is at an angle difference of within 1°, preferably within 0.4° from {100} plane.

Further in the later case, the electron source comprises a part of spherical face, and its radius is preferably from 5 to 100 µm, more preferably from 15 to 50 µm.

This single crystal rod 1 is attached by spot welding to a filament 3 made of tungsten attached to an insulator 5 via a conductive terminal 4 (Fig. 1).

Subsequently, hydrogened zirconium powder is pulverized in a motor and mixed with an organic solvent to form a slurry, and the slurry was applied to a part of the single crystal rod 1, and it was heated in an oxygen atmosphere of preferably from 1×10⁻⁶ Torr (1.3×10⁻⁴ Pa) to 3×10⁻⁶ Torr (4×10⁻⁴ Pa) to thermally decompose the hydrogened product, and further, it was oxidized to form a diffusion source 2 made of zirconium oxide, and at the same time, the surface of the single crystal rod 1 is coated with zirconium and oxide.

This single crystal rod 1 is disposed between the extractor electrode 7 and the suppressor electrode 6, and a negative high voltage of a few kilovolts with respect to the extractor electrode 7 is applied to the single crystal rod 1, and a negative voltage of a few hundred volts with respect to the single crystal rod 1 is applied to the suppressor electrode 6, and electric current is applied to the filament to heat the single crystal rod 1 at from 1,500 to 1,900 K to perform electron emission.

### EXAMPLES

Next, the present invention is more specifically described with an Example and a Comparative Example, but the present invention should not be construed as limited to the following Example.

### EXAMPLE

A tungsten single crystal of <100> orientation is cut into a rod of rectangular solid shape of 2 mm × 0.4 mm × 0.4 mm by electric discharge machining, and is fabricated into the shape of Fig. 3(c) by mechanical polishing. The apex is further polished with a diamond polishing agent to remove fabrication damage to provide an electron emitting portion 8 (Fig. 3(d)). The full apex angle 25 of a first truncated cone portion or cone portion 23 is 90°, and the full apex angle 24 of a second truncated cone portion 22 is 30°. Further, the shape of electron emitting portion 8 is circular and its diameter is 39 µm.

This single crystal rod 1 is attached by spot welding to a filament 3 made of tungsten attached by welding to a conductive terminal 4 brazed to an insulator 5 (Fig. 1).

Subsequently, a hydrogened zirconium powder was pulverized in a motor and mixed with an organic solvent to form a slurry, and the slurry is applied to a part of the single crystal rod 1, and in an oxygen atmosphere of 3×10⁻⁶ Torr (4×10⁻⁸ Pa), an electric current is applied to the filament to heat the single crystal rod to thermally decompose the hydrogened product and further oxidize it to form a diffusion source 2 made of zirconium oxide, and at the same time, the surface of the single crystal rod 1 is coated with zirconium and oxygen.

This electron source was taken out and attached to an electron emission characteristic measurement apparatus having the construction shown in Fig. 2. The leading edge of the single crystal rod 1 is disposed between the suppressor electrode 6 and the extractor electrode 7. Here, the distance between the leading edge of the single crystal rod 1 and the suppressor electrode 6 is 0.25 mm, the distance between the suppressor electrode 6 and the extractor electrode 7 is 0.8 mm, the diameter of a hole in the extractor electrode 7 is 0.8 mm, and the diameter of a hole in the suppressor electrode 6 is 0.6 mm.

The filament 3 is connected to a filament-heating power source 17, and further connected to a cathode high voltage power source 16, and a high negative voltage with respect to the extractor electrode 7 is applied to the filament 3 as an emitter voltage V_{E}. Further, the suppressor electrode 6 is connected to a suppressor power source 15, and a negative voltage with respect to the single crystal rod 1 is further applied to the suppressor electrode 6 as a suppressor voltage V_{S}. By this voltage application, emission of hot electrons from the filament 3 is shielded. Total emission current Iₜ from the electron source is measured by an electric current meter 18 disposed between the cathode high voltage power source 16 and the earth. Emitted electron beam 19 emitted from the electron emitting portion 8 at the leading edge of the single crystal rod 1 passes through a hole of the extractor electrode 7, and reaches to a screen electrode 11. At the center of the screen electrode 11, an aperture 12 (small hole) is present, and a probe current Iₚ passing through the aperture and reaching to a cup-shaped electrode 13 is measured by a microelectoric current meter 14. Here, provided that a solid angle calculated from the distance between the aperture 12 and the leading edge of the single crystal rod 1 and an inner diameter of the aperture 12 is designated as ω, the angular intensity Ip' is represented by Iₚ/ω. Further, a fluorescer was applied on the screen electrode 11 so that a pattern of electron emission distribution could be visually observed,

Inside of the measurement apparatus is evacuated to a ultrahigh vacuum of 3×10⁻¹⁰ Torr (4×10⁻⁸ Pa) and while the temperature of the single crystal rod 1 is maintained at 1,800 K, a suppressor voltage V_{S}=-300 V with respect to the single crystal rod 1 is applied to the suppressor 6, and further, an emitter voltage V_{E}=-3,600 V that is a high voltage, is applied to the single crystal rod 1 and this state was maintained until emission current became stable. Thereafter, emitter voltage V_{E} dependences of total emission current It and probe current Ip (angular intensity) were measured.

### COMPARATIVE EXAMPLE

A conventional electron source was produced as a Comparative Example. Namely, in the same manner as Example, a tungsten single liquid crystal of <100> orientation was cut into a rectangular solid having a cross section of 2 mm × 0.4 mm × 0.4 mm by electric discharge machining, and fabricated it into a shape of Fig. 3(a) by mechanical polishing, and an electron emitting portion 8 was provided at the apex (Fig. 3(b)). The full apex angle 21 of a cone portion 9 is 90°, and the diameter of the electron emitting portion 8 is 23 µm. Production steps after the shape fabrication are the same as those of Example, and electron emitting properties were measured under the same electrode construction and dimensions as those of Example.

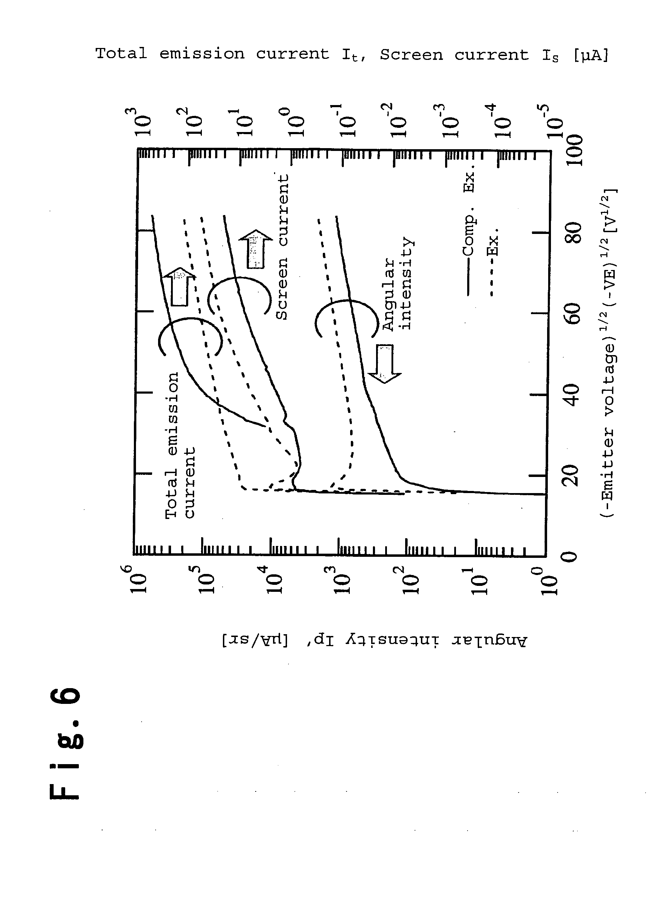

Fig. 6 shows angular intensity Ip', screen current I_{S} and total emission current Iₜ in relation to emitter voltage V_{E}, that were measured and compared results. Further, angular intensity Ip', screen current I_{S} and electrode current I_{EXT} flowing into the extractor electrode 7 at an elector voltage V_{E}=-6,000 V are shown in Table 1. In Comparative Example, I_{EXT} is a high value of 420 µA. On the other hand, in Example, I_{EXT} was an extreme low value of 58 µA, and it was confirmed that I_{EXT} being a surplus current was suppressed.

**TABLE 1**

| | Angular intensity Ip' [µA/sr] | Screen current Is [µA] | Total emission current It [µA] | I_{EXT}= Iₜ-I_{S} [µA] |
|---|---|---|---|---|
| Ex. | 1,872 | 46.7 | 105 | 58 |
| Comp. Ex. | 1,065 | 16.7 | 437 | 420 |

As described above, the electron source of the present invention has high reliability since surplus current is low even when it is operated at high angular intensity, that is, at high electric current. Further, this electron source operates in a vacuum of at most 1×10⁻⁸ Torr (1.3×10⁻⁶ Pa), and since its base material is tungsten, the cathode is hardly worn and change of its characteristics is little even by long term operation.

Here, explanation has been made using an example in which hydrogened zirconium is used as a raw material for diffusion source, but instead, hydrogened titanium or hydrogened hafnium may be employed so as to form a diffusion source that is titanium or hafnium and oxygen covering the single crystal rod 1. Further, an oxide of a metal element selected from the group consisting of Ca, Sr, Ba, Sc, Y, La, Ti, Zr, Hf and lanthanoide elements, may be directly applied to form a diffusion source.

### INDUSTRIAL APPLICABILITY

The electron source of the present invention is an electron source in which surplus current from a side face of a single crystal rod being an electron emitting member can be efficiently suppressed, that has high reliability in high current operation, and accordingly, the electron source of the present invention is suitable as an electron source for electron beam lithography machines, wafer inspection apparatuses and electron beam LSI testers etc., that require high electric current operation, and is extremely useful in industry.

The entire disclosure of Japanese Patent Application No. 2006-261668 filed on September 27, 2006 including specification, claims, drawings and summary is incorporated herein by reference in its entirety.

## Claims

1. An electron source comprising an electron emitting portion, a suppressor electrode and an extractor electrode, wherein the electron emitting portion is present at a leading edge of an end of a single crystal rod having a shape comprising a first truncated cone portion or a cone portion, and a second truncated cone portion continuing therefrom.

2. The electron source according to Claim 1, wherein the single crystal rod has an oxide of a metal element selected from the group consisting of Ca, Sr, Ba, Sc, Y, La, Ti, Zr, Hf and lanthanoide elements as a diffusion source, and the single crystal rod is made of tungsten or molybden of <100> orientation.

3. The electron source according to Claim 1 or 2, wherein the electron emitting portion is present between the suppressor electrode and the extractor electrode.

4. The electron source according to any one of Claims 1 to 3, wherein the apex angle of the first truncated cone portion or the cone portion is at least 60° and at most 150° in terms of full angle, and the apex angle of the second truncated cone portion is at least 20° in terms of full angle.

5. The electron source according to any one of Claims 1 to 4, wherein the electron emitting portion comprises a flat face, and the flat face is within 1° from {100} crystal plane in terms of angle difference.

6. The electron source according to any one of Claims 1 to 4, wherein the electron emitting portion comprises a part of a spherical face.
